# DEMANDE DE BREVET EUROPEEN

(11) **EP 4 012 498 A1**
(43) Date de publication de la demande: **15.06.2022**
(21) Numéro de dépôt: 21217760.4
(22) Date de dépôt: 05.09.2019
(51) Int. Cl.: G03F 7/00, B81C 99/00, C25D 5/22, C25D 5/02, C25D 1/02, C25D 1/20

(54) **PROCÉDÉ POUR FABRIQUER UNE PLURALITÉ DE MICROPIÈCES**

(62) Demande divisionnaire de: 19195755.4
(71) Demandeur: Mimotec S.A., 1950 Sion (CH)
(72) Inventeur: GENOLET, Grégoire, 1926 Fully (CH); LORENZ, Hubert, 1965 Savièse (CH); DEVANTHERY, Fabien, 3967 Vercorin (CH)
(74) Mandataire: Wenger, Joel-Théophile

(57) **Abrégé**

La présente demande concerne le domaine de la fabrication de composants micromécaniques métalliques par électroformage dénommés micropièces.

Pour éviter de détériorer les pièces une fois fabriquées, il est proposé un procédé pour fabriquer une pluralité de micropièces comprenant les étapes de:
a) déposer et irradier une couche de photorésist appliquée sur un substrat (1) conducteur, polymériser la couche de photorésist,
b) éliminer la couche de photorésist non polymérisée, la couche restante de photorésist formant un moule (2),
c) déposer une couche métallique (3) par électroformage dans le moule (2), ladite couche métallique formant des micropièces ayant une face externe correspondant à la partie supérieure de la croissance métallique et une face interne définie par le substrat,
d) réaliser un usinage sur les faces externes pour leur donner leur hauteur finale et leur aspect final,
e) appliquer un film de transfert (4) sur les faces externes
f) libérer du substrat conducteur (1) l'ensemble formé par la couche de photorésist, le film de transfert et la pluralité de micropièces,
g) éliminer la couche de photorésist.

## Description

### Introduction

La présente demande concerne le domaine de la fabrication de composants micromécaniques métalliques par électroformage dénommés micropièces.

### Arrière-plan technique

Le procédé de fabrication de composants micromécaniques par irradiation d'une couche photosensible aux rayons ultraviolets suivie d'une étape d'électroformage est connu et décrit dans la publication EP 3508916.

Ce procédé est dérivé de la technique LIGA (Lithographie Galvanoformung Abformung) et consiste à :
- déposer sur un substrat une couche de 1 à 1000 µm d'une résine photosensible appelée photorésist,
- effectuer si nécessaire un aplanissage de la couche de photorésist par usinage mécanique,
- effectuer à travers un masque une irradiation au moyen d'un synchrotron ou par une exposition aux rayons ultraviolets,
- développer, c'est-à-dire éliminer par des moyens chimiques les portions de photorésist non polymérisées et créer de ce fait une cavité ou moule en photorésist,
- réaliser un dorage sélectif sur les surfaces supérieures de la cavité en photorésist dans le cas de la réalisation de cavité à plusieurs niveaux,
- répéter les étapes précédentes pour réaliser des cavités à plusieurs niveaux,
- électroformer un métal dans cette cavité afin d'obtenir le composant micromécanique,
- la face supérieure et finale de l'électroformage définissant la face externe de la micropièce par opposition à la face interne de la micropièce définie par le substrat.

L'avantage de cette technique est de réaliser des composants micromécaniques d'une très grande précision en X et Y et avec une épaisseur allant jusqu'à plusieurs millimètres. Il est également possible d'appliquer le procédé en plusieurs étapes pour obtenir un composant à plusieurs niveaux, chaque niveau étant construit sur le précédent.

Bien que la précision en X et Y soit satisfaisante, la précision en hauteur (Z) va dépendre de plusieurs facteurs comme la taille des cavités, la hauteur du photorésist et l'épaisseur de métal déposée. C'est pourquoi lorsque la hauteur d'une micropièce doit être définie avec précision, une opération mécanique va être appliquée sur les faces externes des micropièces. De plus, selon les besoins, une étape de finition doit être appliquée sur les faces externes des micropièces.

Les micropièces sont ensuite libérées de leur moule et séparées du substrat. A ce stade les micropièces sont en vrac et leur face interne peut également subir une étape de finition ou de terminaison horlogère.

Les étapes de finition de la face interne et la mise en sachet ou dans des emballages adéquats des micropièces nécessitent de manipuler chaque composant individuellement. Ces dernières opérations peuvent générer des défauts comme des griffures, des rayures voire même des cassures.

Par ailleurs, la publication EP3453787 divulgue un procédé permettant la fabrication et la réalisation de finitions horlogères sur les deux faces d'une pluralité de micropièces sans aucune manipulation unitaire de ces dernières. Ce document propose en effet un procédé de fabrication d'un lot de pièces métalliques, comportant les étapes suivantes:
- se munir d'un substrat comportant une face supérieure électriquement conductrice ;
- structurer une couche de résine photosensible déposée sur le substrat, afin de fabriquer un moule comportant des cavités dont la face supérieure du substrat constitue le fond ;
- remplir de métal les cavités du moule par dépôt galvanique de manière à former un lot de pièces métalliques intégrées dans le moule, le moule et les pièces métalliques formant une structure comportant une surface inférieure collée à la face supérieure du substrat et une surface supérieure ;
- durant une première étape d'usinage mécanique, mettre à niveau puis façonner la surface supérieure de la structure par un usinage sélectif,
- libérer la structure du substrat ;
- fixer la structure sur un support en position retournée, de manière que ce soit la surface supérieure de la structure qui se trouve en regard du support et la surface inférieure qui est exposée ;
- façonner la surf ace inférieure de la structure durant une deuxième étape d'usinage mécanique, avant de libérer la structure du support ;
- libérer les pièces métalliques du moule.

### Description sommaire de l'invention

Le but de la présente invention est de proposer une méthode de fabrication d'une pluralité de micropièces tout en permettant de les protéger dans des conditions optimales durant et après leur fabrication.

La présente invention permet la fabrication et la réalisation des finitions horlogères sur les deux faces de la pluralité des micropièces sans aucune manipulation unitaire de ces dernières; ce type de procédé qui s'applique sur une pluralité de pièces est communément appelé « batch process ».

Il est proposé un procédé pour fabriquer une pluralité de micropièces comprenant les étapes de:
a) déposer et irradier une couche de photorésist appliquée sur un substrat (1) conducteur, polymériser la couche de photorésist ,
b) éliminer la couche de photorésist non polymérisée, la couche restante de photorésist formant un moule (2),
c) déposer une couche métallique (3) par électroformage dans le moule (2), ladite couche métallique formant des micropièces ayant une face externe correspondant à la partie supérieure de la croissance métallique et une face interne définie par le substrat,
d) réaliser un usinage sur les faces externes pour leur donner leur hauteur finale et leur aspect final,
e) appliquer un film de transfert (4) sur les faces externes
f) libérer du substrat conducteur (1) l'ensemble formé par la couche de photorésist, le film de transfert et la pluralité de micropièces,
g) éliminer la couche de photorésist.

Selon les étapes de ce procédé, les micropièces sont maintenues sur un support tout au long de leur finition.

### Brève description des figures

La présente demande sera expliquée à l'aide des figures à savoir :
- la figure 1 décrit le procédé de l'invention
- les figures 2 à 4 sont des exemples de pièces réalisées selon le procédé de l'invention.
- la figure 5 illustre une pluralité de micropièces sur le substrat
- la figure 6 illustre la pluralité de micropièces liée sur un film de transport souple

### Description détaillée des figures

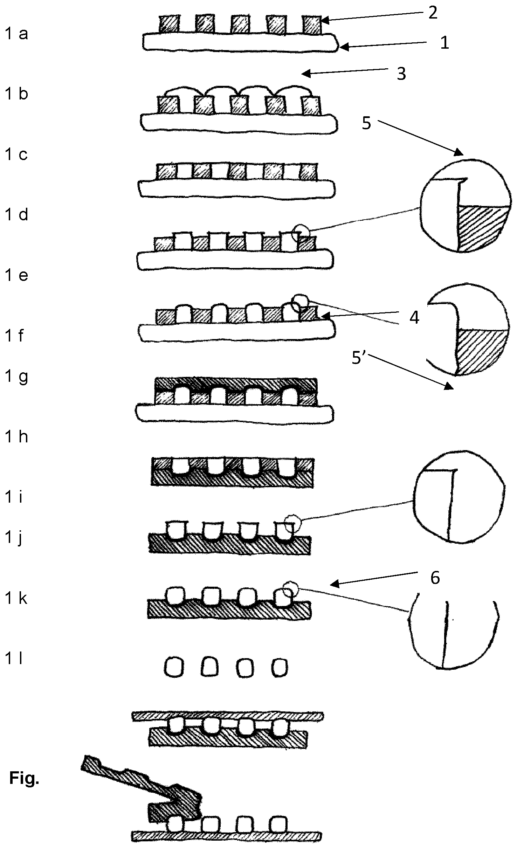

Le procédé permettant de créer une pluralité de micropièces ayant une terminaison sur leurs deux faces et liées via un film de transport à la fin de leur fabrication est expliqué étapes par étapes ci-dessous et fait référence à la figure 1, les premières étapes étant similaires à la méthode connue du LIGA.
a) déposer, aplanir si nécessaire et irradier au travers d'un photomasque une couche de photorésist appliquée sur un substrat 1 recouvert d'une couche conductrice (non illustré sur les figures), la couche de photorésist irradiée est polymérisée. On élimine ensuite la couche de photorésist non polymérisée, le photorésist restant formant un moule en photorésist 2, (voir fig. 1a),
b) déposer une couche métallique 3 par électroformage dans le moule, ladite couche métallique formant une pluralité de micropièces ayant une face externe correspondant à la partie supérieure de la croissance métallique et une face interne définie par le substrat 1, (voir fig. 1b),
c) éliminer les parties métalliques des faces externes supérieures à la côte désirée en épaisseur de la pluralité de micropièces des cavités du moule, cette étape d'élimination s'effectuant soit par meulage, par rodage ou par usinage diamant ou par une combinaison de méthodes précitées, (voir fig. 1c),
d) attaquer partiellement le moule en photorésist 2 de manière à réduire sa hauteur de 10% à 90%, cette étape étant réalisée par attaque chimique humide ou sèche contrôlée, la durée de l'attaque définissant la réduction de la hauteur du photorésist et laissant apparaître un relief formé des faces externes de la pluralité des micropièces, des faces latérales libres de photorésist de ces dernières et de la face externe du moule en photorésist cette étape libérant également les bavures 5 d'usinage créées à l'étape c)(voir fig. 1d),
e) réaliser un usinage sur les faces externes pour leur donner leur aspect final, cette étape consistant en un anglage, un satinage, un cerclage, un poli bloqué ou toute autre opération de finition horlogère, cette étape efface notamment toutes les bavures d'usinage 5 (voir fig. 1e),
f) appliquer un film de transfert 4 sur les faces externes, cette étape consistant à recouvrir l'ensemble par un film souple épousant les reliefs, (voir fig. 1f),
g) détacher du substrat 1 et de la couche conductrice l'ensemble formé par le moule en photorésist 2, le film de transfert 4 et la couche métallique 3, (voir fig. 1g),
h) éliminer complètement le moule en photorésist 2, cette étape laissant apparaître parfois des bavures 5' (voir fig. 1h),
i) réaliser un usinage sur les faces internes pour leur donner leur aspect final en utilisant des méthodes de finition similaires à celles décrites au point e, (voir fig. 1i),
j) selon un premier mode de réalisation les pièces sont séparées de la couche de transfert 4 pour être conditionnées et le procédé se termine à cette étape j) (voir fig. 1j).

Selon une variante du procédé après l'étape i), on réalise les opérations suivantes :
k) appliquer un film de transport 6 sur les faces internes de la pluralité de micropièces, (voir fig. 1k),
l) le film de transfert 4 est alors retiré et la pluralité de micropièces est disposée sur film de transport 6 (voir fig. 1l).

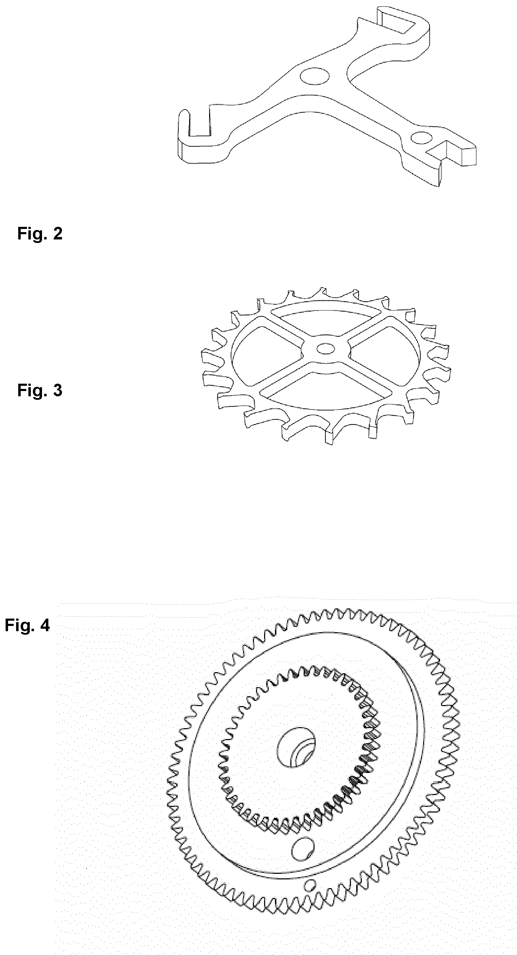

La figure 2 est une ancre d'horlogerie pouvant être réalisée entièrement selon le procédé de ce brevet et ses variantes.

La figure 3 est une roue d'échappement d'un mouvement horloger pouvant être réalisée entièrement selon le procédé de ce brevet et ses variantes.

La figure 4 est un composant horloger comportant plusieurs étages de denture. Ce type de micropièces à plusieurs étages peut aussi être réalisé selon le procédé de la présente invention et ses variantes.

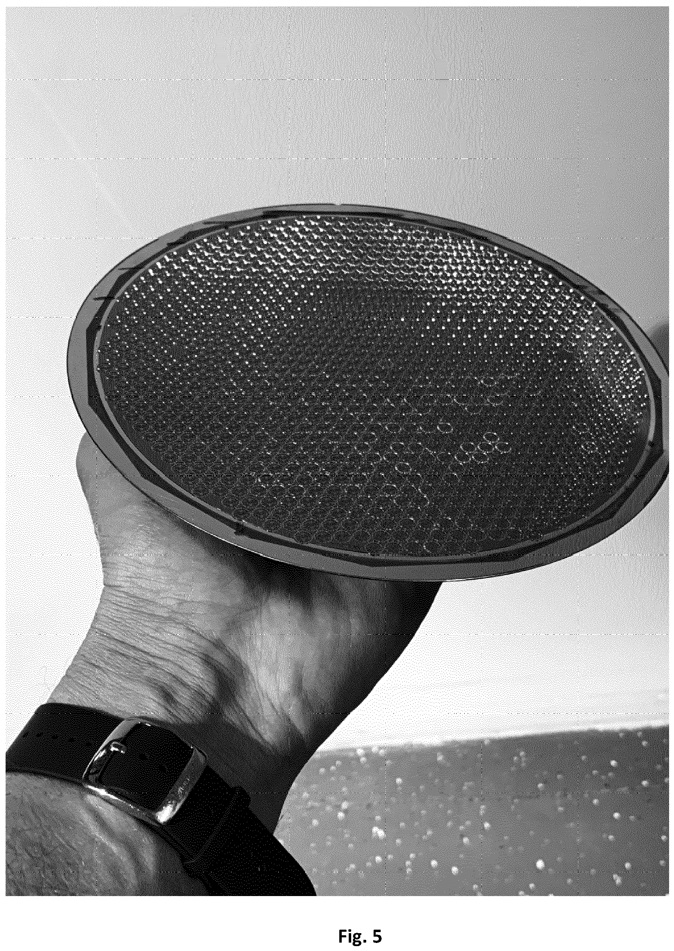

La figure 5 est une photographie d'un ensemble tel que réalisé après l'étape c) du procédé décrit ci-dessus. La pluralité de micropièces est liée et maintenue ensemble par le substrat et le moule en photorésist. Comme illustré sur cette figure le procédé permet de réaliser les usinages sur les faces externes de la pluralité de micropièces (« batch process »).

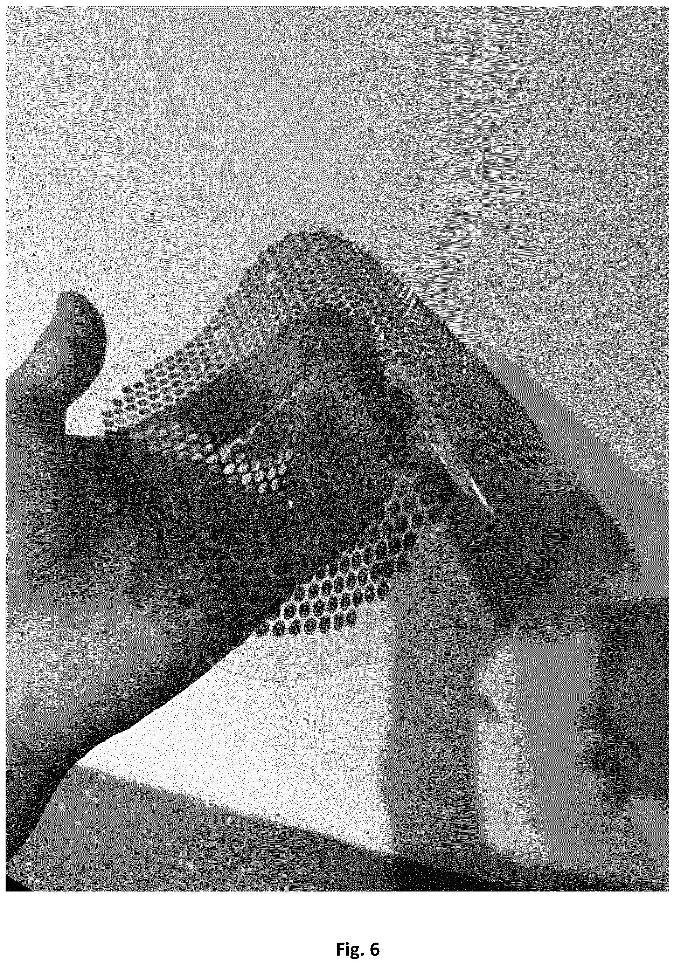

La figure 6 est une photographie du film de transport 6 soutenant la pluralité de micropièces de la figure 3. Dans ce cas précis le film de transport est un film autocollant, flexible et transparent. Dans cet exemple, la pluralité de roues d'échappement illustrée a ses faces internes et externes polies bloquées. Ces opérations de terminaison horlogère ayant été réalisées sans aucune manipulation unitaires des micropièces.

### Description détaillée de l'invention et de ses variantes

Selon la figure 1, le substrat 1 est généralement une plaque-support de verre, de métal ou de silicium sur laquelle est déposée une couche conductrice réalisée par une évaporation de chrome et d'or, par exemple. Sur cette couche conductrice est déposée une couche de photorésist de type négatif sensible aux rayons ultraviolets UV appelée ci-après « photorésist », typiquement de la famille du SU-8 de MicroChem Corporation. Dans le cas d'utilisation d'un substrat métallique l'étape de dépose de la couche conductrice peut être évitée.

Cette couche de photorésist est sélectivement polymérisée après irradiation à travers un photomasque. Les parties irradiées sont polymérisée tandis que les parties masquées ne sont pas polymérisées. Si nécessaire un aplanissage de la couche de photorésist est réalisé avant irradiation.

Durant l'irradiation, la lumière illumine parfaitement perpendiculairement le photomasque, seules les parties 2 de photorésist non protégées par le motif en chrome sont irradiées. Une fois développé, on obtient le moule de la figure 1a.

L'étape suivante consiste à remplir les cavités formées par le moule en photorésist selon une opération d'électroformage, la couche conductrice au fond des cavités permet un dépôt métallique sur le support et lorsque le niveau défini par la couche polymérisée 2 est atteint, le dépôt continue afin de s'assurer que toutes les cavités sont bien remplies. On constate sur la figure 1b un léger débordement de la partie métallique 3. Ce débordement n'est pas nécessaire; par contre l'épaisseur de la partie métallique 3 doit être supérieure à l'épaisseur finale de la micropièce à fabriquer. La figure 1, étape 1b illustre l'état dans lequel l'ensemble se trouve à la fin de ces opérations. La couche métallique électroformée forme une pluralité de micropièces.

Afin de disposer d'une épaisseur précise des micropièces ainsi fabriquées, une première étape de mise à niveau est effectuée. Les micropièces sont solidaires du support et l'ensemble des micropièces est traité dans cette opération. Une manière de faire est le meulage, le support 1 avec la pluralité de micropièces 3 est placé sous une meule (aussi appelé rectifieuse) qui va réduire la hauteur des parties métalliques 3 et éventuellement les parties de photorésist 2 à la hauteur souhaitée. D'autres méthodes alternatives peuvent être mises en oeuvre telle que le rodage ou l'usinage avec un burin diamanté (« fly-cutting »).

Après cette étape de mise à niveau, l'ensemble est comme illustré à l'étape 1c de la figure 1. La partie métallique, en particulier le bord des faces externes, présente des angles vifs, résultants de l'étape de mise à niveau. Il est à noter que l'étape de mise d'épaisseur peut laisser des débordements des faces externes vers la couche de photorésist communément appelés des bavures d'usinage 5.

Afin de pouvoir traiter proprement les faces externes des pièces, le moule en photorésist est en partie retiré par une opération d'attaque chimique. Cette attaque va permettre de réduire la hauteur du moule en photorésist de 10% à 90% pour au moins dégager les angles vifs des faces externes de la couche métallique (au moins 10% de réduction) et également pour permettre les opérations de finition ou de terminaison horlogères. Le solde du moule en photorésist et le substrat garde la pluralité de micropièces liées entre elles. L'homme du métier choisira le temps d'attaque chimique en fonction de la réduction souhaitée de hauteur du moule en photorésist.

L'étape 1d illustre le résultat après une réduction d'env. 30% du photorésist. On voit aussi dans cette figure que la face externe des micropièces présente des bavures 5 résultant de l'opération de mise d'épaisseur. La mise d'épaisseur va réduire la hauteur de la partie métallique mais également avoir une action de repousser des résidus métalliques aux angles vifs. L'étape de finition de la partie supérieure va donc supprimer ces résidus, éventuellement arrondir les angles et donner l'aspect final désiré à la face externe de la pièce. Ceci est illustré à l'étape 1e.

Afin de terminer les micropièces, les faces internes, en contact avec le support vont également subir une étape de finition. Pour cela, on applique un film de transfert 4 sur la pluralité de micropièces. Ceci est illustré par l'étape 1f. Selon une variante d'exécution le film de transfert est de type semi-rigide de la famille des films CONDOx de la maison Disco et il est appliqué par lamination sous vide. Selon une autre variante d'exécution, le film de transfert est réalisé par l'application d'une résine soluble par exemple de la gomme laque de marque liqBo 041 de la maison Stettler Sapphire.

Ce film de transfert 4 a pour but de lier toutes les micropièces en épousant le relief formé des faces externes de la pluralité des micropièces, des faces latérales libres de photorésist de ces dernières et de la face externe du moule en photorésist et permettre ainsi une manipulation de cet ensemble en une seule opération lorsque le substrat et le solde du moule en photorésist seront retirés. Une fois le film de transfert 4 appliqué, cet ensemble formé par la couche métallique 2 (ou la pluralité de micropièces), le résidu du moule en photorésist 2 et le film de transfert 4 est libéré du support 1 et de la couche conductrice. On obtient l'ensemble illustré à l'étape 1g. Une méthode pour cette libération est un usinage mécanique du substrat. Cette étape d'usinage peut également former des bavures 5' sur les arêtes des faces internes (voir grossissement de l'étape 1h).

Par attaque chimique humide ou sèche, le solde du moule en photorésist 2 est supprimé, laissant apparaître les faces internes des micropièces, ces faces internes étant initialement en contact avec le support 1.

On obtient un ensemble tel qu'illustré à l'étape 1h. Une opération de finition est ensuite appliquée sur les faces internes de la même manière que sur l'ensemble illustré à l'étape 1d.

Selon la première variante de l'invention, les micropièces sont terminées et peuvent être séparées du film de transfert 4 pour être conditionnées comme illustré à la figure 1j.

Selon une seconde variante, on applique un film de transport 6 sur les faces internes des micropièces pour les maintenir ensemble. Ceci est illustré à l'étape 1k.

Le film de transport 6 est appelé communément dans l'industrie microélectronique « blue tape », ce type de film est utilisé dans cette industrie pour permettre le sciage des wafers. Ce film est adapté à la manipulation ultérieure des pièces de manière manuelle ou automatisée (« pick-and-place »). A ce stade ces deux films protègent efficacement la finition et l'aspect final de la face interne et externe de la pluralité de micropièces. L'ensemble peut être livré ainsi à des clients.

Une fois les micropièces en contact avec le film de transport 6, le film de transfert 4 est supprimé, comme illustré à l'étape 1l. A ce stade la pluralité de micropièces peut subir les contrôles qualité esthétiques et dimensionnels de manière simplifiée et sans manipulation unitaire.

Les micropièces sont détachées du film de transport 6 dans l'atelier où les elles seront utilisées, à savoir dans un atelier d'assemblage horloger dans le cas du montage d'un mouvement de montre.

Selon une troisième variante de l'invention, après l'enlèvement du film de transfert, on applique un film protecteur sur les faces externes afin d'augmenter la tenue de la pluralité de micropièces et de protéger également cette face durant le transport. Le film protecteur est typiquement un film en polyéthylène 3104C de la marque 3M. Dans cette variante ce film protecteur sera enlevé avant la détache de la pluralité de micropièces du film de transport.

L'exemple ci-dessus a été décrit pour des pièces à un niveau ou un étage. Ce procédé peut être appliqué à des micropièces à plusieurs étages.

Pour ce faire, la première étape est de réaliser un moule multi-niveaux. Une première solution est de déposer une couche de photorésist, d'illuminer cette couche au travers d'un premier masque, dépôt d'une seconde couche de photorésist et illumination au travers d'un second masque. Il est possible bien entendu de répéter ces opérations pour ajouter une ou plusieurs couches au moule souhaité.

Au développement, les parties non polymérisées des différentes couches de photorésist sont éliminées pour obtenir un moule en photorésist à plusieurs niveaux.

Alternativement selon une deuxième solution, il est possible de développer la couche de photorésist c'est-à-dire éliminer la partie non polymérisée avant d'appliquer la couche suivante.

Pour que l'étape de dépôt de la couche métallique soit optimale, il faut que les faces horizontales du moule soient conductrices, en particulier les faces horizontales de ou des couches intermédiaires mais que les faces verticales du moule ne soient pas conductrices. Pour ce faire, une première méthode est décrite dans la demande EP 18165150.6 du même déposant.

Une autre méthode a été décrite dans le document EP 3 508 916 qui consiste à déposer une métallisation sur les faces horizontales sur chaque couche de photorésist développé avant d'ajouter la couche supérieure.

Dans les deux cas, on obtient un moule multi-niveaux avec une métallisation sur les faces horizontales dudit moule. Ce moule est prêt pour l'étape 1b consistant à déposer la couche métallique dans ledit moule. A ce stade de la fabrication d'une pluralité de micropièces à plusieurs étages, les étapes décrites en référence aux figures 1b à 1k s'applique de la même manière. Il est à noter que la terminaison sur les faces internes peut également atteindre les faces internes horizontales d'un niveau intermédiaire, par exemple par l'utilisation d'une brosse rotative.

### Application

Les micropièces ainsi réalisées peuvent être utilisées dans l'horlogerie, notamment pour la réalisation de composants de mouvements de montre mécanique tel que des roues dentées, des ancres, des roues d'ancres, des sautoirs, des cames ou des ressorts.

Ce procédé permet également de fabriquer des pointes de test (« Mems Probe ») pour la mesure de composants microélectroniques. Avec ce procédé il est également possible de fabriquer toute sorte de composants communément réalisés en technologie LIGA.

## Revendications

1. Procédé pour fabriquer une pluralité de micropièces comprenant les étapes de:
a) déposer et irradier une couche de photorésist appliquée sur un substrat (1) conducteur, polymériser la couche de photorésist ,
b) éliminer la couche de photorésist non polymérisée, la couche restante de photorésist formant un moule (2),
c) déposer une couche métallique (3) par électroformage dans le moule (2), ladite couche métallique formant des micropièces ayant une face externe correspondant à la partie supérieure de la croissance métallique et une face interne définie par le substrat,
d) réaliser un usinage sur les faces externes pour leur donner leur hauteur finale et leur aspect final,
e) appliquer un film de transfert (4) sur les faces externes
f) libérer du substrat conducteur (1) l'ensemble formé par la couche de photorésist, le film de transfert et la pluralité de micropièces,
g) éliminer la couche de photorésist.

2. Procédé selon la revendication 1, **caractérisé en ce que** l'étape d) comprend : éliminer les parties métalliques des faces externes débordant des cavités du moule, attaquer la couche de photorésist de manière à réduire sa hauteur de 10% à 90%, usiner les faces externes pour leur donner leur hauteur finale et leur aspect final.

3. Procédé selon l'une des revendications 1 ou 2, **caractérisé en ce qu'**il comprend, après l'étape f) ou l'étape g), une étape de réaliser un usinage sur les faces internes pour leur donner leur aspect final.

4. Procédé selon l'une des revendications 1 à 3, **caractérisé en ce qu'**il comprend, après l'étape g) ou l'étape de la revendication 3, une étape d'application d'un film de transport (6) sur les faces internes des micropièces.

5. Procédé selon l'une des revendications 1 à 4, **caractérisé en ce qu'**il comprend, après l'étape g) ou l'étape d'une des revendications 3 ou 4, une étape d'enlever le film de transfert (4).

6. Procédé selon la revendication précédente, **caractérisé en ce qu'**on applique un film protecteur sur la face externe afin de protéger les faces externes de la pluralité de micropièces durant le transport et le stockage.

7. Procédé selon l'une des revendications 1 à 6, **caractérisé en ce que** le film de transfert (4) est de type semi-rigide ou est réalisé par l'application d'une résine soluble.

8. Procédé selon l'une des revendications 1 à 7, **caractérisé en ce qu'**il comprend:
- après l'étape b), répéter au moins une fois les étapes a) et b) afin d'obtenir un moule multi-niveaux,
- appliquer une métallisation sélective sur les faces horizontales du moule avant l'étape c).

9. Procédé selon l'une des revendications 1 à 7, **caractérisé en ce qu'**il comprend:
x) après l'étape b), appliquer une métallisation sélective sur les faces horizontales supérieures du moule,
xx) répéter au moins une fois les étapes a), b) et x) afin d'obtenir un moule multi-niveaux avant de procéder à l'étape c), l'étape x) n'étant pas nécessaire lors de la dernière itération.

10. Procédé selon l'une des revendications 1 à 7, **caractérisé en ce qu'**il comprend :
- après l'étape a), répéter au moins une fois l'étape a) avant d'effectuer l'étape b) afin d'obtenir un moule multi-niveaux,
- appliquer une métallisation sélective sur les faces horizontales du moule avant l'étape c).

11. Procédé selon l'une des revendications 1 à 7, **caractérisé en ce qu'**il comprend :
x) après l'étape a), appliquer une métallisation sur les faces horizontales du photoresist polymérisé,
xx) répéter au moins une fois les étapes a) et x) avant l'étape b) afin d'obtenir un moule multi-niveaux avant de procéder à l'étape c), l'étape x) n'étant pas nécessaire lors de la dernière itération.

12. Procédé selon l'une des revendications 1 à 7, **caractérisé en ce qu'**il comprend :
x) après l'étape a), appliquer une métallisation sur les faces horizontales du photoresist polymérisé avant de procéder à l'étape b),
xx) répéter au moins une fois les étapes a), x) et b) afin d'obtenir un moule multi-niveaux avant de procéder à l'étape c), l'étape x) n'étant pas nécessaire lors de la dernière itération.

13. Procédé selon l'une des revendications 1 à 12, **caractérisé en ce que** l'étape d'usinage en d) ou l'étape de la revendication 3 consiste en un anglage, un satinage, un cerclage, un poli bloqué ou toute autre opération de finition horlogère .

14. Procédé selon l'une des revendications 1 à 13, **caractérisé en ce qu'**il comprend une étape d'aplanir au moins une couche de photorésist déposée avant son irradiation.

15. Procédé selon l'une des revendications 3 à 14, **caractérisé en ce que** l'étape d'usiner les faces internes atteint les faces internes d'un niveau intermédiaire.
